# EUROPÄISCHE PATENTSCHRIFT

(11) **EP 2 412 040 B1**
(45) Veröffentlichungstag und Bekanntmachung des Hinweises auf die Patenterteilung: **18.07.2018**
(21) Anmeldenummer: 10710030.7
(22) Anmeldetag: 22.03.2010
(51) Int. Cl.: H01L 51/52, H01L 51/44

(54) **DÜNNSCHICHTVERKAPSELUNG FÜR EIN OPTOELEKTRONISCHES BAUELEMENT, VERFAHREN ZU DESSEN HERSTELLUNG UND OPTOELEKTRONISCHES BAUELEMENT**
THIN-LAYER ENCAPSULATION FOR AN OPTOELECTRONIC COMPONENT, METHOD FOR THE PRODUCTION THEREOF, AND OPTOELECTRONIC COMPONENT
ENCAPSULATION EN COUCHES MINCES POUR UN COMPOSANT OPTOÉLECTRONIQUE, SON PROCÉDÉ DE FABRICATION ET COMPOSANT OPTOÉLECTRONIQUE

(30) Priorität: 24.03.2009 DE 102009014543; 09.06.2009 DE 102009024411
(43) Veröffentlichungstag der Anmeldung: 01.02.2012
(60) Teilanmeldung: 12161502.5
(73) Patentinhaber: OSRAM OLED GmbH, 93049 Regensburg (DE)
(72) Erfinder: BECKER, Dirk, 84085 Langquaid (DE); DOBBERTIN, Thomas, 93051 Regensburg (DE); LANG, Erwin, 93051 Regensburg (DE); REUSCH, Thilo, 93055 Regensburg (DE)
(74) Vertreter: Epping - Hermann - Fischer
(86) Internationale Anmeldenummer: PCT/EP2010/053717
(87) Internationale Veröffentlichungsnummer: WO 2010/108894

(56) Entgegenhaltungen:
- US-A1- 2005 181 535
- US-A1- 2006 017 383
- US-A1- 2007 295 390
- US-A1- 2008 182 101
- US-A1- 2008 196 664
- MEYER J., GÖRRN P., BERTRAM F., HAMWI S., WINKLER T., JOHANNES H-H., WEIMANN T., HINZE P., RIEDL T., KOWALSKY W.: "Al2O3/ZrO2 Nanolaminates as Utrahigh Gas-Diffusion Barriers- A Strategy for Reliable Encapsulation of Organic Electronics" ADVANCED MATERIALS, Bd. 21, Nr. 18, 19. Februar 2009 (2009-02-19), Seiten 1845-1849, XP002586026
- DAMERON A.A., DAVIDSON S.D., BURTON B.B., CARCIA P.F., MCLEAN R.S., GEORGE S.M.: "Gas Diffusion Barriers on Polymers Using Multilayers Fabricated by Al2O3 and Rapid SiO2 Atomic Layer Deposition" JOURNAL OF PHYSICAL CHEMISTRY C, Bd. 112, Nr. 12, 5. März 2008 (2008-03-05) , Seiten 4573-4580, XP002586027
- PARK S-H K, OH J, HWANG C-S, LEE J-I, YANG Y S, CHU H Y, KANG K-Y: "Ultra Thin Film Encapsulation of organic light emitting diode on a plastic substrate" ETRI JOURNAL, Bd. 27, Nr. 5, 31. Oktober 2005 (2005-10-31), Seiten 545-550, XP002586028

## Beschreibung

Die vorliegende Anmeldung betrifft eine Dünnschichtverkapselung für ein optoelektronisches Bauelement, ein Verfahren zu dessen Herstellung und ein optoelektronisches Bauelement.

Optoelektronische Bauelemente und insbesondere solche, die ein organisches funktionelles Material aufweisen, wie beispielsweise organische Leuchtdioden (OLEDs), sind außerordentlich empfindlich gegenüber Feuchtigkeit und Sauerstoff. Zum Schutz vor Feuchtigkeit und Sauerstoff werden OLEDs beispielsweise in der Regel aufwändig mit Glaskavitäten verkapselt, die auf das Bauteil geklebt werden.

Weiterhin sind Dünnschichtverkapselungen mit dünnen Schichten bekannt, die das Bauelement gegen Feuchtigkeit und Sauerstoff abdichten. Eine solche Dünnschichtverkapselung ist beispielsweise in den Anmeldungen DE 10 2008 031 405, DE 10 2008 048 472 und DE 10 2008 019 900 beschrieben. Die hierin beschriebene Dünnschichtverkapselung hat insbesondere den Nachteil, für sichtbares Licht nur eine geringe optische Transmission aufzuweisen. US 2006/017383 A1 offenbart eine Dünnschichtverkapselung für ein optoelektronisches Bauelement mit einer Schichtenfolge, die folgende Schichten umfasst: eine erste mittels Atomlagenabscheidung abgeschiedene ALD-Schicht, die aus Titanoxid besteht, und eine zweite mittels Atomlagenabscheidung abgeschiedene ALD-Schicht, die aus Aluminiumoxid besteht, wobei die Schichtenfolge eine Vielzahl an ersten ALD-Schichten und zweiten ALD-Schichten aufweist, die sich periodisch wiederholen. Aufgabe der vorliegenden Erfindung ist es, eine verbesserte Dünnschichtverkapselung für ein optoelektronisches Bauelement anzugeben. Insbesondere soll die Dünnschichtverkapselung eine gute optische Transmission für sichtbares Licht aufweisen. Weiterhin ist es Aufgabe der vorliegenden Anmeldung, ein Verfahren zur Herstellung der Dünnschichtverkapselung und ein optoelektronisches Bauelement mit einer solchen Dünnschichtverkapselung anzugeben.

Diese Aufgaben werden durch eine Dünnschichtverkapselung mit den Merkmalen des Patentanspruches 1, ein optoelektronisches Bauelement mit den Merkmalen des Patentanspruches 5, sowie durch ein Verfahren gemäß Patentanspruch 10 gelöst. Vorteilhafte Ausführungsformen sowie Weiterbildungen der vorliegenden Erfindung sind in den jeweils abhängigen Ansprüchen angegeben.

Unter "Dünnschichtverkapselung" wird vorliegend eine Vorrichtung verstanden, die dazu geeignet ist, eine Barriere gegenüber atmosphärischen Stoffen, insbesondere gegenüber Feuchtigkeit und Sauerstoff, zu bilden. Mit anderen Worten ist die Dünnschichtverkapselung derart ausgebildet, dass sie von atmosphärischen Stoffen, wie Wasser oder Sauerstoff, höchstens zu sehr geringen Anteilen durchdrungen werden kann. Diese Barrierewirkung wird bei der Dünnschichtverkapselung im Wesentlichen durch dünne Schichten erzeugt, die Teil der Dünnschichtverkapselung sind. Die Schichten der Dünnschichtverkapselung weisen in der Regel eine Dicke kleiner oder gleich einiger 100 nm auf.

Gemäß einer Ausführungsform besteht die Dünnschichtverkapselung aus den dünnen Schichten, die für die Barrierewirkung der Dünnschichtverkapselung verantwortlich sind.

Eine Dünnschichtverkapselung für ein optoelektronisches Bauelement mit einer guten Transmission für sichtbares Licht weist gemäß der Erfindung eine Schichtenfolge auf, die folgende Schichten umfasst: eine erste mittels Atomlagenabscheidung abgeschiedene ALD-Schicht, die aus Titanoxid besteht, und eine zweite mittels Atomlagenabscheidung abgeschiedene ALD-Schicht, die aus Lanthanoxid besteht, wobei die Schichtenfolge eine Vielzahl an ersten ALD-Schichten und zweiten ALD-Schichten aufweist, die sich periodisch wiederholen und in direktem Kontakt miteinander stehen, und eine Außenfläche der Dünnfilmverkapselung durch eine ALD-Schicht gebildet ist, die aus Titanoxid besteht. Es sei an dieser Stelle darauf hingewiesen, dass die Schichtenfolge weitere ALD-Schichten aufweisen kann. Ebenso kann die Schichtenfolge weitere Schichten aufweisen, die mittels anderer Verfahren als Atomlagenabscheidung erzeugt wurden.

Eine Schichtenfolge, die nur ALD-Schichten aufweist, wird vorliegend auch als "Nanolaminat" bezeichnet.

Mit "Atomlagenabscheidung" ("atomic layer deposition", ALD) ist vorliegend ein Verfahren bezeichnet, bei dem eine erste gasförmige Ausgangsverbindung einem Volumen zugeführt wird, in dem eine zu beschichtende Oberfläche bereitgestellt ist, so dass die erste gasförmige Verbindung auf der Oberfläche adsorbieren kann. Nach einer bevorzugt vollständigen oder nahezu vollständigen Bedeckung der Oberfläche mit der ersten Ausgangsverbindung wird der Teil der ersten Ausgangsverbindung, der noch gasförmig und/oder nicht auf der Oberfläche adsorbiert vorliegt, in der Regel wieder aus dem Volumen entfernt und eine zweite Ausgangsverbindung zugeführt. Die zweite Ausgangsverbindung ist dafür vorgesehen, mit der an der Oberfläche adsorbierten, ersten Ausgangsverbindung unter Bildung einer festen ALD-Schicht chemisch zu reagieren.

Es sei an dieser Stelle darauf hingewiesen, dass bei der Atomlagenabscheidung auch mehr als zwei Ausgangsverbindungen zum Einsatz kommen können.

Bei der Atomlagenabscheidung ist es in der Regel vorteilhaft, wenn die zu beschichtende Oberfläche auf eine Temperatur über Raumtemperatur erhitzt wird. Dadurch kann die Reaktion zur Bildung der festen ALD-Schicht thermisch initiiert werden. Die Temperatur der zu beschichteten Oberfläche ist hierbei in der Regel von den Ausgangsverbindungen abhängig.

Eine plasmalose Atomlagenabscheidung ("plasma-less atomic layer deposition", PLALD) bezeichnet vorliegend ein ALD-Verfahren, für das kein Plasma wie im Folgenden beschrieben, erzeugt wird, sondern bei dem zur Bildung der festen Schicht, die Reaktion der Ausgangsverbindungen nur über die Temperatur der zu beschichtenden Oberfläche initiiert wird.

Die Temperatur der zu beschichtenden Oberfläche liegt bei einem PLALD-Verfahren in der Regel zwischen 60°C und 120°C, wobei die Grenzen eingeschlossen sind.

Eine plasmaunterstützte Atomlagenabscheidung ("plasma enhanced atomic layer deposition", PEALD) bezeichnet vorliegend weiterhin ein ALD-Verfahren, bei dem die zweite Ausgangsverbindung bei gleichzeitiger Erzeugung eines Plasmas zugeführt wird, wodurch die zweite Ausgangsverbindung angeregt werden soll. Dadurch kann - im Vergleich zu einem plasmalosen ALD-Verfahren - die Temperatur, auf die die zu beschichtende Oberfläche aufgeheizt werden muss, verringert werden und durch die Plasmaerzeugung dennoch die Reaktion zwischen den Ausgangsverbindungen initiiert werden. Bevorzugt ist die Temperatur der zu beschichteten Oberfläche bei PEALD kleiner oder gleich 120°C, besonders bevorzugt kleiner oder gleich 80°C.

Insbesondere kann ein PEALD-Verfahren vorteilhaft sein, wenn eine Initiierung der Reaktion zwischen den Ausgangsverbindungen eine Oberflächentemperatur erforderlich macht, bei der das zu verkapselnde Bauelement geschädigt werden könnte.

Bei der Dünnschichtverkapselung befindet sich die erste ALD-Schicht in direktem Kontakt mit der zweiten ALD-Schicht. Dies bedeutet, dass die erste ALD-Schicht und die zweite ALD-Schicht eine gemeinsame Grenzfläche aufweisen. Gemäß der Erfindung besteht die erste mittels Atomlagenabscheidung abgeschiedene ALD-Schicht aus Titanoxid. Die zweite mittels Atomlagenabscheidung abgeschiedene ALD-Schicht besteht aus Lanthanoxid. Bevorzugt sind die ALD-Schichten der Schichtenfolge besonders dünn ausgebildet, beispielsweise weisen diese eine Dicke zwischen einer Atomlage und 10 nm auf, wobei die Grenzen eingeschlossen sind. Dies trägt in der Regel zu einer hohen optischen Transmission der Dünnschichtverkapselung bei.

Gemäß einer weiteren Ausführungsform umfasst die Schichtenfolge der Dünnschichtverkapselung zumindest eine weitere Schicht, die durch thermisches Aufdampfen oder mittels eines plasmagestützten Prozesses, wie Sputtern oder Plasma-Enhanced Chemical Vapour Deposition (PECVD) abgeschieden wurde.

Geeignete Materialien für die weitere Schicht sind: Siliziumnitrid, Siliziumoxid, Siliziumoxinitrid, Indiumzinnoxid, Indiumzinkoxid, Aluminium-dotiertes Zinkoxid, Aluminiumoxid sowie deren Mischungen und Legierungen.

Die weitere Schicht weist beispielsweise eine Dicke zwischen 1 nm und 5 µm auf, wobei die Grenzen eingeschlossen sind. Besonders bevorzugt weist die weitere Schicht eine Dicke zwischen 1 nm und 400 nm auf, wobei wiederum die Grenzen eingeschlossen sind.

Gemäß einer bevorzugten Ausführungsform der Dünnschichtverkapselung weist diese ein Nanolaminat auf, an das in direktem Kontakt eine weitere Schicht angeordnet ist.

Eine besonders bevorzugte Dünnschichtverkapselung, die eine hohe optische Transmission für sichtbares Licht sowie eine besonders gute hermetische Barrierewirkung gewährleistet, weist eine weitere Schicht auf, die mittels eines plasmagestützten Prozesses aufgebracht ist und Siliziumnitrid umfasst oder aus Siliziumnitrid besteht.

Zusätzlich oder alternativ ist es auch möglich, dass die Schichtenfolge der Dünnschichtverkapselung eine weitere ALD-Schicht aufweist. Diese weitere ALD-Schicht kann beispielsweise eines der folgenden Materialien aufweisen oder aus zumindest einem dieser Materialien bestehen: Aluminiumoxid, Zinkoxid, Zirkoniumoxid, Titanoxid, Hafniumoxid, Lanthaniumoxid. Gemäß der Erfindung wird eine Außenfläche der Dünnfilmverkapselung durch eine ALD-Schicht gebildet ist, die aus Titanoxid besteht. Gemäß der Dünnschichtverkapselung der Erfindung wiederholen sich die Schichten der Schichtenfolge periodisch. Besonders bevorzugt weist die Dünnschichtverkapselung ein Nanolaminat auf, dessen ALD-Schichten sich innerhalb des Nanolaminates mehrfach oder periodisch wiederholen. Hierdurch kann vorteilhafterweise eine besonders dichte Dünnschichtverkapselung erzielt werden.

Bei der vorliegenden Dünnschichtverkapselung ist es vorteilhafterweise möglich, durch geeignete Auswahl der einzelnen Schichten, insbesondere hinsichtlich Dicke und Materialien der Schichten, die optischen Eigenschaften der Dünnschichtverkapselung auf gewünschte Art und Weise anzupassen. So kann beispielsweise durch eine geeignete Auswahl von Schichtdicken und Materialien der Schichten der Transmissionsgrad und die Reflektivität der Dünnschichtverkapselung auf gewünschte Art und Weise angepasst werden. Vorteilhafterweise kann etwa eine Dünnschichtverkapselung mit Entspiegelungswirkung oder mit einem gewünschten Transmissionsgrad erzielt werden.

Die Dünnschichtverkapselung weist besonders bevorzugt eine Transmission für sichtbares Licht auf, die größer oder gleich 70% ist. Besonders bevorzugt ist die Transmission der Dünnschichtverkapselung für sichtbares Licht größer oder gleich 90 %.

Die vorliegende Dünnschichtverkapselung ist insbesondere für optoelektronische Bauelemente geeignet, da ihre optischen Eigenschaften auf gewünschte Art und Weise angepasst werden kann.

Ein optoelektronisches Bauelement umfasst insbesondere:
- ein Substrat,
- eine aktive, strahlungserzeugende und/oder strahlungsempfangende Zone, die auf dem Substrat aufgebracht ist, und
- eine Dünnschichtverkapselung, wie sie oben beschrieben wurde.

Die Dünnschichtverkapselung ist bevorzugt zwischen der aktiven Zone und dem Substrat aufgebracht. Diese Anordnung schützt vorteilhafterweise insbesondere die empfindliche aktive Zone.

Zur Herstellung einer solchen Anordnung wird in der Regel erst die Dünnschichtverkapselung auf das Substrat aufgebracht und anschließend die aktive Zone über der Dünnschichtverkapselung.

Die vorliegende Dünnschichtverkapselung ist insbesondere geeignet, auf flexible Substrate, wie beispielsweise Metallfolien oder Kunststofffolien aufgebracht zu werden, da diese aufgrund der geringen Dicke der Dünnschichtverkapselung ihre Flexibilität durch die Dünnschichtverkapselung nicht verlieren.

Gemäß einer weiteren bevorzugten Ausführungsform ist die Dünnschichtverkapselung derart über der aktiven Zone angebracht, dass die in der aktiven Zone erzeugte oder empfangene Strahlung durch die Dünnschichtverkapselung hindurch läuft.

Die vorliegende Dünnschichtverkapselung ist insbesondere geeignet, bei einer organischen Leuchtdiode, einer organischen Fotovoltaikzelle, einer Solarzelle angewendet zu werden oder bei einem optoelektronischen Bauelement, das eine organische Elektronik - wie z.B. Transistoren, Dioden oder organische integrierte Schaltkreise - aufweist.

Bei dem Verfahren zur Herstellung einer Dünnschichtverkapselung für ein optoelektronisches Bauelement werden eine erste ALD-Schicht und eine zweite ALD-Schicht jeweils mittels Atomlagenabscheidung abgeschieden. Die zuvor im Zusammenhang mit der Dünnschichtverkapselung beschriebenen vorteilhaften Ausgestaltungen gelten analog auch für das Verfahren. Das Verfahren zur Herstellung einer Dünnschichtverkapselung für ein optoelektronisches Bauelement gemäß Anspruch 10 umfasst die Schritte: Abscheiden einer ersten ALD-Schicht mittels Atomlagenabscheidung, die aus Titanoxid besteht, und Abscheiden einer zweiten ALD-Schicht mittels Atomlagenabscheidung, die aus Lanthanoxid besteht, wobei die Schichtenfolge eine Vielzahl an ersten ALD-Schichten und zweiten ALD-Schichten aufweist, die sich periodisch wiederholen und in direktem Kontakt miteinander stehen, und eine Außenfläche der Dünnfilmverkapselung durch eine ALD-Schicht gebildet ist, die aus Titanoxid besteht. Weitere vorteilhafte Ausführungsformen und Weiterbildungen der Erfindung ergeben sich aus den im Folgenden in Verbindung mit den Figuren beschriebenen Ausführungsbeispielen.

Es zeigen:
Figuren 1 bis 3 schematische Schnittdarstellungen jeweils einer Dünnschichtverkapselung gemäß jeweils einem Ausführungsbeispiel, und
Figuren 4 bis 6 schematische Schnittdarstellungen jeweils eines optoelektronischen Bauelementes gemäß jeweils einem Ausführungsbeispiel.

In den Ausführungsbeispielen und Figuren sind gleiche oder gleich wirkende Bestandteile jeweils mit den gleichen Bezugszeichen versehen. Die dargestellten Elemente und deren Größenverhältnisse untereinander sind nicht als maßstabsgerecht anzusehen, vielmehr können einzelne Elemente, insbesondere Schichtdicken, zum besseren Verständnis übertrieben groß dargestellt sein.

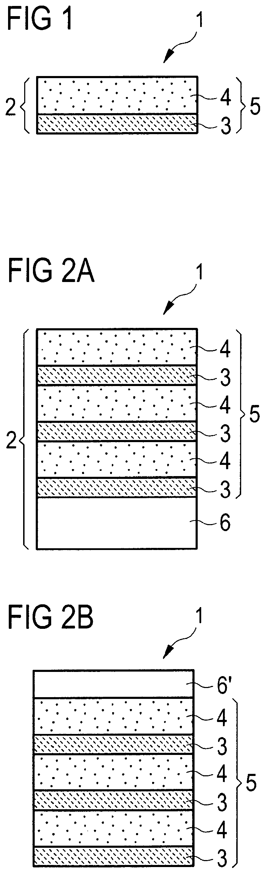

Die Dünnschichtverkapselung 1 gemäß dem Ausführungsbeispiel der Figur 1 umfasst eine Schichtenfolge 2 mit einer ersten ALD-Schicht 3, die mit Atomlagenabscheidung abgeschieden wurde und einer zweiten ALD-Schicht 4, die ebenfalls mit Atomlagenabscheidung abgeschieden wurde. Die erste ALD-Schicht 3 und die zweite ALD-Schicht 4 stehen insbesondere in direktem Kontakt miteinander. In einem Beispiel, welches nicht Teil der Erfindung ist, umfasst oder besteht die erste ALD-Schicht 3 aus Aluminiumoxid, während die zweite ALD-Schicht 4 aus Zinkoxid besteht oder Zinkoxid aufweist. Da die beiden ALD-Schichten 3, 4 vorliegend aus zwei verschiedenen Materialien bestehen, ist deren Transmission gegenüber sichtbarem Licht erhöht, da Interferenzeffekte, die bei einer einzigen ALD-Schicht die Transmission erniedrigen können, zumindest vermindert werden. Weiterhin hat die Verwendung zweier verschiedener Materialien für die erste ALD-Schicht 3 und die zweite ALD-Schicht 4 den Vorteil, dass kleine Diffusionskanäle in den ALD-Schichten 3, 4 besser geschlossen werden können.

Weitere geeignete Materialien für die ALD-Schichten 3, 4, welche nicht Gegenstand der Erfindung sind, sind beispielsweise Zirkoniumoxid, und Hafniumoxid. Gemäß der Erfindung besteht die erste mittels Atomlagenabscheidung abgeschiedene ALD-Schicht aus Titanoxid und besteht die zweite mittels Atomlagenabscheidung abgeschiedene ALD-Schicht aus Lanthanoxid. Die Dicke der ersten ALD-Schicht 3 liegt bei dem Ausführungsbeispiel gemäß Figur 1 bei ca. 10 nm, während die zweite ALD-Schicht 4 eine Dicke von ca. 1 nm aufweist.

Die beiden ALD-Schichten 3, 4 gemäß dem Ausführungsbeispiel der Figur 1 bilden ein Nanolaminat 5 aus. Ein solches Nanolaminat 5 alleine kann geeignet sein, eine ausreichende Barrierewirkung gegenüber atmosphärischen Einflüssen wie Feuchtigkeit oder Sauerstoff darzustellen.

Eine Dünnschichtverkapselung 1 gemäß der vorliegenden Anmeldung ist durch ein Nanolaminat 5 gebildet, bei dem sich die ALD-Schichten 3, 4 periodisch wiederholen.

Die Dünnschichtverkapselung 1 gemäß dem Ausführungsbeispiel der Figur 2A weist beispielsweise ein Nanolaminat 5 auf, bei dem sich die ALD-Schichten 3, 4 des Nanolaminats gemäß Figur 1 drei Mal periodisch wiederholen.

Die ALD-Schichten 3, 4 sind herbei jeweils in direktem Kontakt miteinander angeordnet, dass heißt, sie bilden jeweils eine gemeinsame Grenzfläche aus.

Bei einer besonders bevorzugten Ausführungsform wiederholen sich die ALD-Schichten 3, 4 des Nanolaminats 5 der Figur 1 mindestens fünfmal. Dies ist aus Gründen der Übersichtlichkeit nicht dargestellt.

Neben dem Nanolaminat 5 weist die Schichtenfolge 2 der Dünnschichtverkapselung 1 gemäß Figur 2A zusätzlich eine weitere Schicht 6 auf, die nicht mittels Atomlagenabscheidung aufgebracht ist, sondern beispielsweise durch thermisches Verdampfen oder plasmagestützte Verfahren, wie etwa Sputtern oder PECVD.

Die weitere Schicht 6 ist hierbei in direktem Kontakt mit der äußersten ersten ALD-Schicht 3 des Nanolaminats 5 angeordnet.

Bei dem Ausführungsbeispiel der Figur 2A weist die weitere Schicht 6 Siliziumnitrid auf oder besteht aus Siliziumnitrid und hat eine Dicke von beispielsweise ca. 90 nm.

Für die weitere Schicht 6 sind neben Siliziumnitrid die Materialien Siliziumoxid, Siliziumoxinitrid, Indiumzinnoxid, Indiumzinkoxid, Aluminium-dotiertes Zinkoxid Aluminiumoxid sowie deren Mischungen und Legierungen geeignet.

Die Dünnschichtverkapselung 1 gemäß dem Ausführungsbeispiel der Figur 2B, welches nicht Teil der Erfindung ist, weist eine erste ALD-Schicht 3 auf, die wie bei dem Ausführungsbeispiel gemäß Figur 2A Aluminiumoxid aufweist oder aus Aluminiumoxid besteht. Weiterhin weist die Dünnschichtverkapselung 1 eine zweite ALD-Schicht 4 auf, die Titanoxid aufweist oder aus Titanoxid besteht. Die erste ALD-Schicht 3 ist in direktem Kontakt auf die zweiten ALD-Schicht 4 aufgebracht. Das Nanolaminat 5 gemäß dem Ausführungsbeispiel der Figur 2B, welches nicht Teil der Erfindung ist, wird durch eine dreifache periodische Wiederholung einer ersten ALD-Schicht 3, die Aluminiumoxid aufweist oder aus Aluminiumoxid besteht, und einer zweiten ALD-Schicht 4, die Titanoxid aufweist oder aus Titanoxid besteht, gebildet. Weiterhin ist es auch möglich, dass das Nanolaminat 5 durch eine vierfache oder etwa fünfache periodische Wiederholung solcher erste und zweiter ALD-Schichten 3, 4 gebildet ist.

Die Dicke der ersten ALD-Schicht 3 und der zweiten ALD-Schicht 4, liegt bevorzugt zwischen einer Atomlage und 10 nm. Beispielsweise beträgt die Dicke der ersten ALD-Schicht 3, die Aluminiumoxid aufweist oder aus Aluminiumoxid besteht, ca. 2 nm. Die Dicke der zweiten ALD-Schicht 4, die Titanoxid aufweist oder aus Titanoxid besteht, liegt beispielsweise zwischen ca. 7 nm und ca. 9 nm, wobei die Grenzen eingeschlossen sind.

Besonders bevorzugt ist die Dünnschichtverkapselung gemäß dem Ausführungsbeispiel der Figur 2B, welches nicht Teil der Erfindung ist, dazu vorgesehen, mit der ersten ALD-Schicht 3, die Aluminiumoxid aufweist oder aus Aluminiumoxid besteht auf ein optoelektronisches Bauelement aufgebracht zu werden, so dass eine zweite ALD-Schicht 4, die Titanoxid aufweist oder aus Titanoxid besteht, eine Außenfläche der Dünnschichtverkapselung 1 bildet. Weiterhin ist es auch möglich, dass die Schichtenfolge 2 der Dünnschichtverkapselung 1 eine weitere ALD-Schicht 6' aufweist, die ebenfalls Titanoxid aufweist oder aus Titanoxid besteht und die die Außenfläche der Dünnschichtverkapselung 1 bildet. Eine solche weitere ALD-Schicht 6', die Titanoxid aufweist oder aus Titanoxid besteht, weist beispielsweise eine Dicke von ca. 8 nm auf.

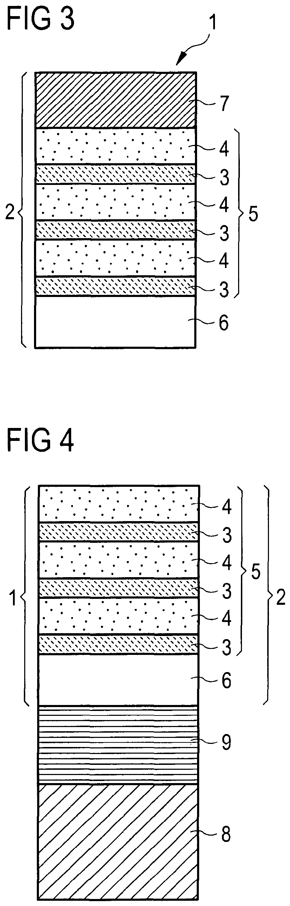

Die Dünnschichtverkapselung 1 gemäß dem Ausführungsbeispiel der Figur 3, welches nicht Teil der Erfindung ist, unterscheidet sich von der Dünnschichtverkapselung 1 gemäß der Figur 2A dadurch, dass deren Schichtenfolge 2 eine zweite weitere Schicht 7 umfasst. Die zweite weitere Schicht 7 ist auf die von der ersten weiteren Schicht 6 abgewandte Seite des Nanolaminats 5 in direktem Kontakt mit diesem aufgebracht. Die zweite weitere Schicht 7 kann dasselbe Material umfassen wie die erste weitere Schicht 6 oder auch ein anderes Material.

Das optoelektronische Bauelement gemäß dem Ausführungsbeispiel der Figur 4 weist ein Substrat 8 auf, auf das eine aktive Zone 9 aufgebracht ist. Die aktive Zone 9 ist vorliegend dazu geeignet, Strahlung zu empfangen oder auszusenden.

Die aktive Zone 9 des Bauelementes umfasst beispielsweise ein organisches funktionelles Material. Alternativ kann die aktive Zone 9 auch ein anorganisches aktives Material aufweisen.

Bei dem optoelektronischen Bauelement kann es sich beispielsweise um eine organische Leuchtdiode, eine organische Fotovoltaikzelle oder eine Solarzelle handeln. Weiterhin kann das optoelektronische Bauelement auch eine organische Elektronik - wie etwa Transistoren Dioden oder organische integrierte Schaltkreise umfassen.

Auf die aktive Zone 9 des optoelektronischen Bauelementes ist eine Dünnschichtverkapselung 1 gemäß dem Ausführungsbeispiel der Figur 2A aufgebracht. Die Dünnschichtverkapselung 1 ist derart auf die aktive Zone 9 aufgebracht, dass die weitere Schicht 6 zur aktiven Zone 9 weist und die in der aktiven Zone 9 erzeugte oder empfangene Strahlung durch die Dünnschichtverkapselung 1 hindurch läuft.

Anstelle der Dünnschichtverkapselung 1 gemäß dem Ausführungsbeispiel der Figur 2A könnte das optoelektronische Bauelement gemäß Figur 4 auch eine Dünnschichtverkapselung 1 gemäß der Ausführungsbeispiele der Figuren 1, 2B und 3 umfassen.

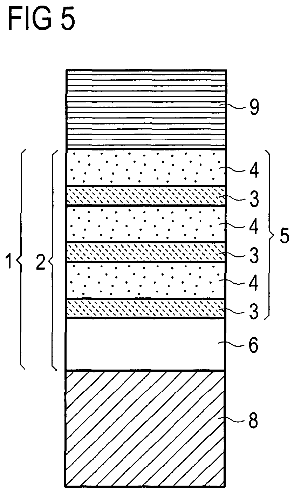

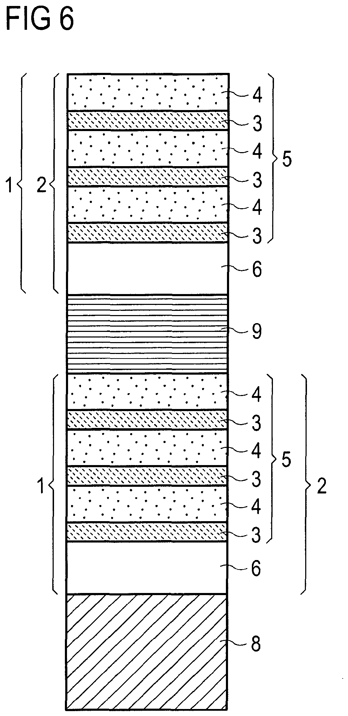

Im Unterschied zu dem Ausführungsbeispiel gemäß der Figur 4 weist das optoelektronische Bauelement gemäß dem Ausführungsbeispiel der Figur 5 eine Dünnschichtverkapselung 1 auf, die zwischen dem Substrat 8 und der aktiven Zone 9 des Bauelementes angeordnet ist. Die weitere Schicht 6 der Dünnschichtverkapselung 1 weist hierbei zu dem Substrat 8. Die aktive Zone 9 ist auf dem Nanolaminat 5 aufgebracht. Das optoelektronische Bauelement gemäß dem Ausführungsbeispiel der Figur 6 weist zwei Dünnschichtverkapselungen 1 auf. Die beiden Dünnschichtverkapselungen 1 sind vorliegend identisch gemäß dem Ausführungsbeispiel der Figur 2A ausgebildet. Sie können aber auch voneinander unterschiedlich ausgebildet sein.

Die erste Dünnschichtverkapselung 1 ist wie bei dem Bauelement gemäß der Figur 5 zwischen Substrat 8 und aktiver Zone 9 angeordnet, während die zweite Dünnschichtverkapselung 1 über der aktiven Zone 9 angeordnet ist, wie bei dem Ausführungsbeispiel der Figur 4.

Die Erfindung ist nicht durch die Beschreibung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Dünnschichtverkapselung (1) für ein optoelektronisches Bauelement mit einer Schichtenfolge (2), die folgende Schichten umfasst:
- eine erste mittels Atomlagenabscheidung abgeschiedene ALD-Schicht (3), die aus Titanoxid besteht, und
- eine zweite mittels Atomlagenabscheidung abgeschiedene ALD-Schicht (4), die aus Lanthanoxid besteht, wobei
- die Schichtenfolge eine Vielzahl an ersten ALD-Schichten (3) und zweiten ALD-Schichten (4) aufweist, die sich periodisch wiederholen und in direktem Kontakt miteinander stehen, und
- eine Außenfläche der Dünnfilmverkapselung durch eine ALD-Schicht gebildet ist, die aus Titanoxid besteht.

2. Dünnschichtverkapselung (1) nach dem vorherigen Anspruch, bei der die Schichtenfolge (2) zumindest eine weitere Schicht (6, 7) aufweist, die mittels eines Plasma-gestützten Prozesses, wie Sputtern oder PECVD, oder durch thermisches Verdampfen abgeschieden wurde.

3. Dünnschichtverkapselung nach dem vorherigen Anspruch, bei dem die weitere Schicht (6, 7) zumindest eines der folgenden Materialien aufweist: Siliziumnitrid, Siliziumoxid, Siliziumoxinitrid, Indiumzinnoxid, Indiumzinkoxid, Aluminium-dotiertes Zinkoxid, Aluminiumoxid sowie deren Mischungen und Legierungen.

4. Dünnschichtverkapselung (1) nach einem der vorherigen Ansprüche, bei der die ALD-Schichten (3, 4) eine Dicke zwischen einer atomaren Lage und 10 nm aufweist, wobei die Grenzen eingeschlossen sind.

5. Optoelektronisches Bauelement mit:
- einem Substrat (8),
- einer aktiven, strahlungserzeugenden und/oder strahlungsempfangenden Zone (9), die auf dem Substrat (8) aufgebracht ist, und
- einer Dünnschichtverkapselung (1) nach einem der obigen Ansprüche.

6. Optoelektronisches Bauelement nach Anspruch 5, bei dem die Dünnschichtverkapselung (1) zwischen Substrat (8) und aktiver Zone (9) angeordnet ist.

7. Optoelektronisches Bauelement nach einem der Ansprüche 5 bis 6, bei dem die Dünnschichtverkapselung (1) derart über der aktiven Zone (9) angebracht ist, dass die in der aktiven Zone (9) erzeugte oder empfangene Strahlung durch die Dünnschichtverkapselung (1) hindurch läuft.

8. Optoelektronisches Bauelement nach einem der Ansprüche 5 bis 7, bei dem das Substrat (8) flexibel ausgebildet ist.

9. Optoelektronisches Bauelement nach einem der Ansprüche 5 bis 8, wobei das optoelektronische Bauelement eine organische Leuchtdiode, eine organische Fotovoltaikzelle, eine Solarzelle ist und/oder eine organische Elektronik aufweist.

10. Verfahren zur Herstellung einer Dünnschichtverkapselung (1) für ein optoelektronisches Bauelement, umfassend die Schritte:
- Abscheiden einer ersten ALD-Schicht (3) mittels Atomlagenabscheidung, die aus Titanoxid besteht, und
- Abscheiden einer zweiten ALD-Schicht (4) mittels Atomlagenabscheidung, die aus Lanthanoxid besteht, wobei
- die Schichtenfolge eine Vielzahl an ersten ALD-Schichten (3) und zweiten ALD-Schichten (4) aufweist, die sich periodisch wiederholen und in direktem Kontakt miteinander stehen, und
- eine Außenfläche der Dünnfilmverkapselung durch eine ALD-Schicht gebildet ist, die aus Titanoxid besteht.

## Claims

1. Thin-film encapsulation (1) for an optoelectronic component with a layer sequence (2) comprising the following layers:
- a first ALD layer (3) deposited by atomic layer deposition, the first ALD layer (3) consisting of titanium oxide, and
- a second ALD layer (4) deposited by atomic layer deposition, the second ALD layer (4) consisting of lanthanum oxide, wherein
- the layer sequence comprises a plurality of first ALD-layers (3) and plurality of second ALD-layers (4), the first ALD-layers (3) and the second ALD-layers (4) are in direct contact with each other and repeated periodically, and
- an outside surface of the thin-film encapsulation is formed by the ALD-layer consisting of titanium oxide.

2. Thin-film encapsulation (1) according to the preceeding claim, wherein the layer sequence (2) comprises at least one further layer (6,7), which is deposited by a plasma-assisted process such as sputtering or PECVD or by thermal evaporation.

3. Thin-film encapsulation (1) according to the preceeding claim, wherein the further layer (6, 7) comprises at least one of the following materials: silicon nitride, silicon oxide, silicon oxynitride, indium tin oxide, indium zinc oxide, aluminum-doped zinc oxide, aluminum oxide and mixtures and alloys thereof.

4. Thin-film encapsulation (1) according to any of the above claims, wherein the ALD layers (3, 4) have a thickness of between one atomic layer and 10 nm, inclusive of the limits.

5. An optoelectronic component, comprising:
- a substrate (8),
- an active, radiation-generating or radiation receiving zone (9), which is applied on the substrate (8), and
- a thin-film encapsulation (1) according to any of the above claims.

6. Optoelectronic component according to claim 5, wherein the thin-film encapsulation (1) is arranged between the substrate (8) and the active zone (9).

7. Optoelectronic component according to any of claims 5 to 6, wherein the thin-film encapsulation (1) is fitted above the active zone (9) in such a way that the radiation generated or received in the active zone (9) passes through the thin-film encapsulation (1).

8. The optoelectronic component according to any of claims 5 to 7, wherein the substrate (8) is embodied in a flexible fashion.

9. The optoelectronic component according to any of claims 5 to 8, wherein the optoelectronic component is an organic light emitting diode, an organic photovoltaic cell, a solar cell and/or comprises organic electronics.

10. A method for producing a thin-film encapsulation (1) for an optoelectronic component comprising the steps:
- depositing a first ALD layer (3) by atomic layer deposition, the first ALD layer (3) consisting of titanium oxide, and
- depositing a second ALD layer (4) by atomic layer deposition, the second ALD layer (4) consisting of lanthanum oxide, wherein
- the layer sequence comprises a plurality of first ALD-layers (3) and plurality of second ALD-layers (4), the first ALD-layers (3) and the second ALD-layers (4) are in direct contact with each other and repeated periodically, and
- an outside surface of the thin-film encapsulation is formed by the ALD-layer consisting of titanium oxide.

## Revendications

1. Encapsulation en couches minces (1) pour un composant optoélectronique comprenant une succession de couches (2) qui comprend les couches suivantes :
- une première couche ALD (3) déposée par dépôt de couches minces atomiques, laquelle consiste en oxyde de titane, et
- une deuxième couche ALD (4) déposée par dépôt de couches minces, laquelle consiste en oxyde de lanthane,
- la succession de couches présentant une pluralité de premières couches ALD (3) et de deuxièmes couches ALD (4) qui se répètent périodiquement et sont en contact direct les unes avec les autres, et
- une surface extérieure de l'encapsulation en couches minces étant formée par une couche ALD consiste en oxyde de titane.

2. Encapsulation en couches minces (1) selon la revendication précédente, dans laquelle la succession de couches (2) présente au moins une couche supplémentaire (6, 7) qui a été déposée au moyen d'un processus assisté par plasma, tel que pulvérisation ou PECVD, ou par évaporation thermique.

3. Encapsulation en couches minces (1) selon la revendication précédente, dans laquelle la couche supplémentaire (6, 7) présente au moins l'une des matières suivantes : nitrure de silicium, oxyde de silicium, oxynitrure de silicium, oxyde d'indium et d'étain, oxyde d'indium et de zinc, oxyde de zinc dopé à l'aluminium, oxyde d'aluminium ainsi que des mélanges et des alliages de ces matières.

4. Encapsulation en couches minces (1) selon l'une quelconque des revendications précédentes, dans laquelle les couches ALD présentent une épaisseur entre une couche atomique et 10 nm, les limites étant incluses.

5. Composant optoélectronique comprenant :
- un substrat (8),
- une zone active (9) générant un rayonnement et/ou recevant un rayonnement, laquelle est placée sur le substrat (8), et
- une encapsulation en couches minces (1) selon l'une quelconque des revendications ci-dessus.

6. Composant optoélectronique selon la revendication 5, dans lequel l'encapsulation en couches minces (1) est disposée entre le substrat (8) et la zone active (9).

7. Composant optoélectronique selon l'une quelconque des revendications 5 à 6, dans lequel l'encapsulation en couches minces (1) est placée au-dessus de la zone active (9) de manière à ce que le rayonnement généré ou reçu dans la zone active (9) traverse l'encapsulation en couches minces (1).

8. Composant optoélectronique selon l'une quelconque des revendications 5 à 7, dans lequel le substrat (8) est conçu de manière flexible.

9. Composant optoélectronique selon l'une quelconque des revendications 5 à 8, le composant optoélectronique étant une diode électroluminescente organique, une cellule photovoltaïque organique, une cellule solaire et/ou présentant une électronique organique.

10. Procédé de fabrication d'une encapsulation en couches minces (1) pour un composant optoélectronique, comprenant les étapes :
- dépôt d'une première couche ALD (3) par dépôt de couches atomiques, laquelle consiste en oxyde de titane, et
- dépôt d'une deuxième couche ALD (4) par dépôt de couches atomiques, laquelle consiste en oxyde de lanthane,
- la succession de couches présentant une pluralité de premières couches ALD (3) et de deuxièmes couches ALD (4) qui se répètent périodiquement et sont en contact direct les unes avec les autres, et
- une surface extérieure de l'encapsulation en couches minces étant formée par une couche ALD qui consiste en oxyde de titane.
